# EUROPÄISCHE PATENTSCHRIFT

(11) **EP 2 822 181 B1**
(45) Veröffentlichungstag und Bekanntmachung des Hinweises auf die Patenterteilung: **28.10.2015**
(21) Anmeldenummer: 13174912.9
(22) Anmeldetag: 03.07.2013
(51) Int. Cl.: H03K 17/94, H03K 17/96

(54) **Sensoranordnung und Verfahren zum Betrieb einer Bedienvorrichtung**
Sensor assembly and method for operating an operating control
Agencement de capteurs et procédé de fonctionnement d'un dispositif de commande

(43) Veröffentlichungstag der Anmeldung: 07.01.2015
(73) Patentinhaber: Siemens Aktiengesellschaft, 80333 München (DE)
(72) Erfinder: Reimann, Michael, 90431 Nürnberg (DE)

(56) Entgegenhaltungen:
- EP-A1- 2 479 894
- DE-A1-102007 008 007
- US-A- 5 410 148

## Beschreibung

Die Erfindung betrifft eine Sensoranordnung, umfassend eine Eingabefläche, unter welcher ein erster kapazitiver Sensor angeordnet ist, ein Mittel zur Auswertung einer Kapazitätsänderung des ersten Sensors, welches mit diesem verbunden ist und ausgestaltet ist ein erstes Ausgangssignal bei einer Kapazitätsänderung bereitzustellen.

Des Weiteren betrifft die Erfindung ein Verfahren zum Betrieb einer Bedienvorrichtung mit zumindest einer Sensoranordnung, wobei einem ersten kapazitiven Sensor eine Eingabefläche zugeordnet wird, wobei ein Berühren der Eingabefläche kapazitiv ausgewertet wird und ein erstes Ausgangssignal für eine Bedienhandlung bereitgestellt wird, dabei wird eine Kapazitätsänderung des ersten kapazitiven Sensors als Bedienhandlung gewertet.

Kapazitive Sensoranordnungen dienen als Bedienelemente für elektrische Geräte, beispielsweise Herdplatten, Kaffeeautomaten, medizinische Geräte oder HMI-Geräte für die industrielle Automatisierung. Ein einzelner kapazitiver Sensor mit einer Auswerteeinheit wandelt eine manuelle Betätigung in ein elektrisches Schaltsignal um, in dem das von dem Sensor ausgesandte elektrische Feld durch das Eindringen eines elektrisch leitenden Objektes, insbesondere eines menschlichen Fingers, verändert wird. Diese Veränderungen des elektrischen Feldes werden durch die Auswerteeinrichtung erfasst, so dass von dieser bei einer entsprechenden Kapazitätsänderung ein Schaltsignal erzeugt wird. Solche Sensoren bzw. Sensoranordnungen werden beispielsweise als Tasten eingesetzt und ermöglichen beispielsweise das Ein- oder Ausschalten von elektrischen Geräten. Dabei sind die kapazitiven Sensoren mit einer Leiterplatte oder mit der Auswerteeinrichtung elektrisch verbunden und werden von dieser mit Strom versorgt und gleichzeitig permanent auf einer Kapazitätsänderung überwacht.

Oftmals dienen Abdeckplatten, insbesondere aus Glas oder einem anderen transparenten nicht leitenden Werkstoff als eine äußere Begrenzung für den Sensor und bilden demnach eine Eingabefläche, die von einem menschlichen Finger oder einem elektrisch leitenden Objekt berührt werden kann. Das von einem kapazitiven Sensor erzeugte Kapazitätsfeld weist eine räumliche Ausdehnung auf und tritt durch die elektrisch nicht leitfähige Abdeckplatte, ohne von dieser abgelenkt zu werden, hindurch, so dass das räumliche Kapazitätsfeld auf der Außenseite der Abdeckplatte im Bereich der Eingabefläche vorhanden ist. Sobald ein Bedienobjekt, beispielsweise ein menschlicher Finger, in das Kapazitätsfeld eindringt, wird diese Kapazitätsfeld-Veränderung von dem Sensor erfasst und an die Auswerteeinrichtung weitergegeben, so dass von diesem Sensor das elektrische Schaltsignal erzeugt wird.

Als nachteilig bei solchen kapazitiven Tasten hat sich herausgestellt, dass auch unbeabsichtigte Schaltvorgänge entstehen können, wenn beispielsweise ein Feuchtigkeitsfilm in den Bereich der Eingabefläche gelangt. Durch den Feuchtigkeitsfilm wird ebenfalls eine Kapazitätsfeld-Veränderung erreicht, die von der Auswerteeinrichtung erfasst wird. Die Auswerteeinrichtung kann demnach nicht unterscheiden, ob die Kapazitätsfeld-Veränderung durch ein bewusstes und korrektes Berühren eines Bedienobjektes, insbesondere eines menschlichen Fingers, oder von einem Feuchtigkeitsfilm hervorgerufen wurde.

In der europäischen Patentanmeldung EP 2 479 894 A1 wird eine kapazitive Taste zur Erzeugung eines elektrisch auswertbaren Schaltsignals offenbart.

Es ist Aufgabe der vorliegenden Erfindung die kapazitive Taste nach EP 2 479 894 A1 im Hinblick auf Fehleingaben, durch beispielsweise Feuchtigkeitsfilme, zu verbessern.

Die Aufgabe wird für die eingangs genannte Sensoranordnung dadurch gelöst, dass die Eingabefläche zumindest eine lichtdurchlässige Teilfläche aufweist und unter der Teilfläche ein optischer Sensor angeordnet ist, wobei der optische Sensor an eine Auswerteeinheit angeschlossen ist und die Auswerteeinheit ausgestaltet ist mittels des optischen Sensors eine Lichtdurchlässigkeits-Messung eines auf der Eingabefläche befindlichen Objektes durchzuführen und ein Präsenzsignal zu erzeugen, wenn eine ermittelte Lichtdurchlässigkeit einen vorgegebenen Wert unterschreitet, dabei ist die Auswerteeinheit weiterhin dazu ausgestaltet, dass erste Ausgangssignal und das Präsenzsignal auszuwerten und bei Vorhandensein beider Signale ein Gültigkeitssignal bereitzustellen. Mittels der Lichtdurchlässigkeits-Messung, also einem optischen Messverfahren, soll erkannt werden, ob sich ein Bedienobjekt, insbesondere ein menschlicher Finger, oder z.B. ein Feuchtigkeitsfilm, insbesondere Wasser, Reinigungsflüssigkeit, oder breiartige Substanzen, wie sie beispielsweise bei der Lebensmittelherstellung entstehen können, auf der Oberfläche des Sensors befindet. Ausgenutzt wird, dass beispielsweise der menschliche Finger, den optischen Sensor deutlich stärker als das Wasser oder die breiartigen Substanzen verdunkelt.

Um die Sensoranordnung weiterhin bezüglich Fehleingaben zu verbessern, ist in der Sensoranordnung eine Ergänzungsfläche angeordnet, unter welcher ein zweiter kapazitiver Sensor angeordnet ist, wobei die Ergänzungsfläche die Eingabefläche zumindest teilweise umgibt, wobei das Mittel zur Auswertung einer Kapazitätsänderung des ersten Sensors zusätzlich ausgestaltet ist, auch eine Kapazitätsänderung des zweiten Sensors auszuwerten und bei einer Kapazitätsänderung ein zweites Ausgangssignal bereitzustellen, dabei ist die Auswerteeinheit weiterhin dazu ausgestaltet, dass zweite Ausgangssignal auszuwerten und bei Vorhandensein des zweiten Ausgangssignals das Gültigkeitssignal wieder zurückzunehmen. Liegt auf der Sensoranordnung, beispielsweise ein Feuchtigkeitsfilm, so wird durch den Feuchtigkeitsfilm auch der zweite kapazitive Sensor der Ergänzungsfläche beeinflusst. Befindet sich jetzt beispielsweise der Finger einer menschlichen Hand exakt in der Mitte der Eingabefläche, wobei durch den optischen Sensor dieses Vorhandensein des menschlichen Fingers auf der Eingabefläche registriert wurde, aber zudem ein Feuchtigkeitsfilm vorhanden ist, welcher eine Fehlmessung hervorrufen könnte, so wird das Gültigkeitssignal, welches aufgrund des optischen Sensors erzeugt wurde, wieder zurückgenommen.

Eine weiter optimierte Ausgestaltung der Sensoranordnung weist innerhalb der Eingabefläche eine Fingermulde auf, wobei der optische Sensor unterhalb der Fingermulde angeordnet ist. Durch eine Fingermulde kann zusätzlich das von der Seite einstrahlende Licht minimiert bzw. gänzlich unterdrückt werden und somit kann ein sicheres Ergebnis für das Vorhandensein eines Bedienobjektes erzeugt werden.

Vorteilhafter Weise ist die Ergänzungsfläche ringförmig um die Eingabefläche angeordnet. Dabei ist es weiterhin von Vorteil, wenn zwischen der Eingabefläche und der Ergänzungsfläche ein Korridor angeordnet ist, welcher im Wesentlichen frei von einem elektrischen Fluss der kapazitiven Sensoren ist. Dadurch ist der erste Sensor und der zweite Sensor voneinander beabstandet angeordnet und es kommt bei einer nicht exakt zentralen Berührung, beispielsweise eines menschlichen Fingers, des ersten Sensors, nicht zu einer Unterdrückung des Gültigkeitssignals.

Auch wird die eingangs genannte Aufgabe durch ein Verfahren zum Betrieb einer Bedienvorrichtung mit zumindest einer Sensoranordnung nach einem der Ansprüche 1 bis 5 gelöst, wobei einem ersten kapazitiven Sensor eine Eingabefläche zugeordnet wird, wobei ein Berühren der Eingabefläche kapazitiv ausgewertet wird und ein erstes Ausgangssignal für eine Bedienhandlung bereitgestellt wird, dabei wird eine Kapazitätsänderung des ersten kapazitiven Sensors als Bedienhandlung gewertet. Um bei der Bedienvorrichtung mit kapazitiven Sensoren Fehleingaben zu vermeiden, wird mittels eines optischen Sensors eine Lichtdurchlässigkeits-Messung eines auf der Eingabefläche befindlichen Objektes durchgeführt und es wird geprüft, ob eine ermittelte Lichtdurchlässigkeit einen vorgegebenen Wert unterschreitet. Bei Unterschreitung des Wertes wird ein Präsenzsignal erzeugt, weiterhin wird geprüft, ob das erste Ausgangssignal und das Präsenzsignal vorhanden sind und bei Vorhandensein beider Signale wird ein Gültigkeitssignal bereitgestellt, wodurch die Bedienhandlung als gültig erkannt wird. Durch die Lichtdurchlässigkeits-Messung bzw. dem daraus resultierenden optischen Messverfahren soll erkannt werden, ob sich beispielsweise ein menschlicher Finger oder ein Feuchtigkeitsfilm auf der Sensoranordnung befindet. Dabei wird ausgenutzt, dass beispielsweise der menschliche Finger den Sensor deutlich stärker als der Feuchtigkeitsfilm verdunkelt.

Das Verfahren wird weiter optimiert, wenn einem zweiten kapazitiven Sensor eine Ergänzungsfläche zugeordnet wird und ein Berühren der Ergänzungsfläche kapazitiv ausgewertet wird und ein zweites Ausgangssignal für ein Berühren der Ergänzungsfläche bereitgestellt wird, dabei wird eine Kapazitätsänderung des zweiten kapazitiven Sensors als Fehlbedienung gewertet, und bei Vorhandensein des zweiten Ausgangssignals wird das Gültigkeitssignal wieder zurückgenommen. Ist die Sensoranordnung beispielsweise in einer HMI-Bedienvorrichtung der industriellen Automatisierung angeordnet und wird diese HMI-Bedienvorrichtung beispielsweise mit einem Wasserstrahl gereinigt, so wird dieser Wasserstrahl beide Sensoren auslösen, welches eine Fehlbedienung zur Folge hätte, aber eine Auswerteeinheit, beispielsweise ein Mikrocontroller, ist dazu ausgestaltet, die Messergebnisse beider kapazitiven Sensoren zu verknüpfen und dementsprechend eine Bedienhandlung als ungültig zu erklären.

Vorzugsweise wird ein elektrischer Fluss des zweiten Sensors im Wesentlichen ringförmig um die Eingabefläche ausgerichtet.

Weiterhin ist es von Vorteil, wenn der elektrische Fluss des zweiten Sensors und ein elektrischer Fluss des ersten Sensors derart ausgerichtet werden, dass zwischen der Eingabefläche und der Ergänzungsfläche ein Korridor entsteht, welcher im Wesentlichen frei von einem elektrischen Fluss der kapazitiven Sensoren ist.

Die Zeichnung zeigt ein Ausführungsbeispiel der Erfindung. Dabei zeigt die
- FIG 1: eine Sensoranordnung in einer Draufsicht und die
- FIG 2: die Sensoranordnung in einer schematisch dargestellten Schnittdarstellung.

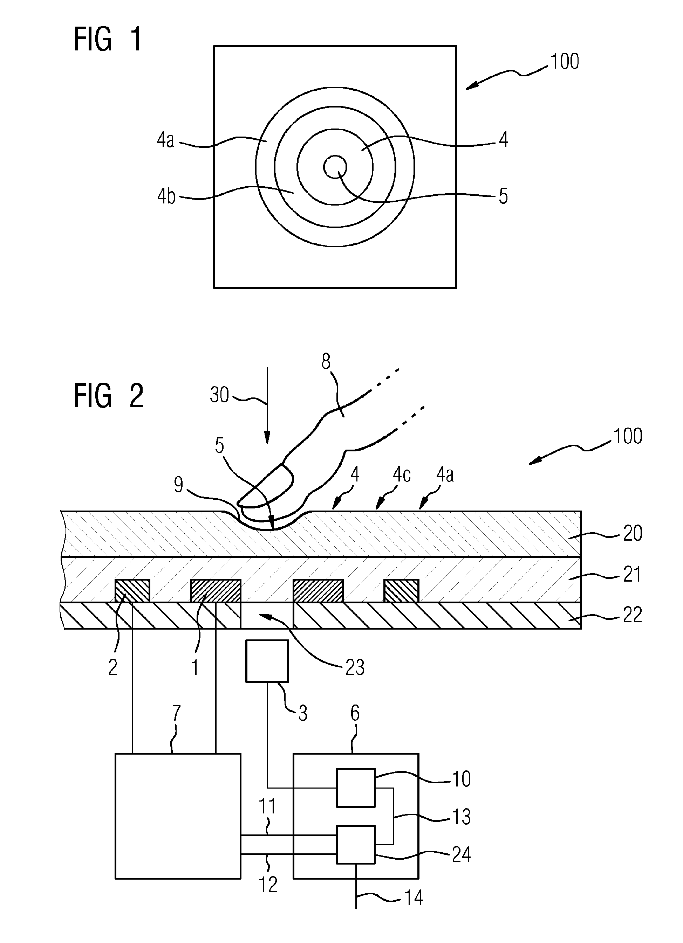

Gemäß FIG 1 ist eine Sensoranordnung 100 dargestellt, umfassend eine Eingabefläche 4 unter welcher ein erster kapazitiver Sensor 1 (siehe FIG 2) angeordnet ist. Um die Eingabefläche 4 ist ringförmig eine Ergänzungsfläche 4a angeordnet. In der Eingabefläche 4 ist eine lichtdurchlässige Teilfläche 5 angeordnet unter der ein optischer Sensor 3 (siehe FIG 2) angeordnet ist. Ist die Sensoranordnung 100, beispielsweise in einer Bedienvorrichtung angeordnet und würde über die Bedienvorrichtung bzw. über die Sensoranordnung 100 ein Wasserfilm fließen, so würde der Wasserfilm die Eingabefläche 4 berühren und eine Kapazitätsänderung hervorrufen, wodurch ein Schaltsignal erzeugt werden würde, welches nicht gewollt ist. Um dies zu verhindern, ist in der Eingabefläche 4 die Teilfläche 5 angeordnet. Da die Teilfläche 5 lichtdurchlässig ist und unter ihr ein optischer Sensor 3 angeordnet ist, wird eine Bedienhandlung an der Sensoranordnung 100 erst für gültig erklärt, wenn mittels des optischen Sensors 3 eine Lichtdurchlässigkeits-Messung eines auf der Eingabefläche 4 befindlichen Objektes 8 (siehe FIG 2) ergeben hat, dass eine ermittelte Lichtdurchlässigkeit einen vorgegebenen Wert unterschritten hat. Ein Finger einer menschlichen Hand beispielsweise wird die Teilfläche 5 demnach verdunkeln, so dass dieses Kriterium erfüllt ist. Ein Wasserfilm hingegen wird die Teilfläche 5 nicht derart verdunkeln.

Mit der FIG 2 ist die aus FIG 1 gezeigte Sensoranordnung 100 in einer Schnittdarstellung abgebildet. Der erste kapazitive Sensor 1 und der zweite kapazitive Sensor 2 sind innerhalb einer transparenten Verbindungsschicht 21 angeordnet. Als Bedienfläche dient eine Schutzschicht 20, beispielsweise aus Glas, die Schutzschicht 20 und die transparente Verbindungsschicht 21 wiederum sind auf einer Trägerplatte 22 angeordnet. Der erste kapazitive Sensor 1 und der zweite kapazitive Sensor 2 sind jeweils an ein Mittel 7 zur Auswertung einer Kapazitätsänderung der Sensoren 1,2 angeschlossen. In der Schutzschicht 20 sind ringförmig die Eingabefläche 4 und die Ergänzungsfläche 4a angeordnet und zwischen der Eingabefläche 4 und der Ergänzungsfläche 4a ist weiterhin ein Korridor 4b angeordnet. In der Mitte des ersten kapazitiven Sensors 1 ist eine Ausnehmung 23 angeordnet, welche lichtdurchlässig ist. Ein Lichteinfall 30 auf die Schutzschicht 20 kann somit durch die Ausnehmung 23 auf einen optischen Sensor 3 gelangen. Der optische Sensor 3 ist wiederum an eine Auswerteeinheit 6 angeschlossen. Die Auswerteeinheit 6 ist dabei ausgestaltet mittels des optischen Sensors 3 eine Lichtdurchlässigkeits-Messung eines auf der Eingabefläche 4 befindlichen Objektes 8, beispielsweise dem Finger einer menschlichen Hand, durchzuführen, und ein Präsenzsignal 13 zu erzeugen, wenn eine ermittelte Lichtdurchlässigkeit einen vorgegebenen Wert unterschreitet. Mit einem Messmittel 10 wird die Lichtdurchlässigkeits-Messung durchgeführt.

Bei einer Kapazitätsänderung des ersten Sensors 1 wird durch das Mittel 7 die Kapazitätsänderung des ersten Sensors 1 mittels eines ersten Ausgangssignals 11 angezeigt. Eine Kapazitätsänderung des zweiten Sensors 2 wird mittels des Mittels 7 als ein zweites Ausgangssignal 12 angezeigt.

Die Auswerteeinheit 6 ist weiterhin dazu ausgestaltet, das erste Ausgangssignal 11 und das Präsenzsignal 13 auszuwerten und bei Vorhandensein beider Signale ein Gültigkeitssignal 14 bereitzustellen.

Um eine Eingabesicherheit weiterhin zu erhöhen, ist die Auswerteeinheit 6 weiterhin dazu ausgestaltet, das zweite Ausgangssignal 12 auszuwerten und bei Vorhandensein des zweiten Ausgangssignals 12 das Gültigkeitssignal 14 wieder zurück zunehmen. Diese Auswertungen der Ausgangssignale 11,12 und des Präsenzsignales 13 werden vorzugsweise in einer Logikschaltung 24 vorgenommen, welche als Ausgang das Gültigkeitssignal 14 bereitstellt.

Als optischen Sensor 3 wird vorzugsweise ein RGB-Farblichtsensor, insbesondere ein siliziumchipbasierender Lichtsensor, insbesondere eine Fotodiode eingesetzt.

Die Sensoranordnung bringt in folgenden Umgebungen eine Verbesserung hinsichtlich des Erkennens von Fehlbedienungen: Umgebungen, welche eine häufige Reinigung benötigen, Umgebungen, welche die Verschmutzung eines Displays einer Bedienvorrichtung durch teiltransparente, leitfähige Stoffe ausgesetzt sind. Eine Grundhelligkeit der Umgebung müsste dabei definiert werden und steht in Abhängigkeit zu Empfindlichkeit des eingesetzten optischen Messverfahrens.

## Patentansprüche

1. Sensoranordnung (100), umfassend
eine Eingabefläche (4), unter welcher ein erster kapazitiver Sensor (1) angeordnet ist,
ein Mittel (7) zur Auswertung einer Kapazitätsänderung des ersten Sensors (1), welches mit diesem verbunden ist und ausgestaltet ist ein erstes Ausgangssignal (11) bei einer Kapazitätsänderung bereitzustellen,
**dadurch gekennzeichnet, dass** die Eingabefläche (4) zumindest eine lichtdurchlässige Teilfläche (5) aufweist und unter der Teilfläche (5) ein optischer Sensor (3) angeordnet ist, wobei der optische Sensor (3) an eine Auswerteeinheit (6) angeschlossen ist und die Auswerteeinheit (6) ausgestaltet ist mittels des optischen Sensors (3) eine Lichtdurchlässigkeits-Messung eines auf der Eingabefläche (4) befindlichen Objektes (8) durchzuführen und ein Präsenzsignal (13) zu erzeugen, wenn eine ermittelte Lichtdurchlässigkeit einen vorgegebenen Wert unterschreitet, dabei ist die Auswerteeinheit (6) weiterhin dazu ausgestaltet das erste Ausgangssignal (11) und das Präsenzsignal (13) auszuwerten und bei Vorhandensein beider Signale ein Gültigkeitssignal (14) bereitzustellen.

2. Sensoranordnung (100) nach Anspruch 1, mit einer Ergänzungsfläche (4a) unter welcher ein zweiter kapazitiver Sensor (2) angeordnet ist, wobei die Ergänzungsfläche (4a) die Eingabefläche (4) zumindest teilweise umgibt, wobei das Mittel (7) zur Auswertung einer Kapazitätsänderung des ersten Sensors (1) zusätzlich ausgestaltet ist auch eine Kapazitätsänderung des zweiten Sensors (2) auszuwerten und bei einer Kapazitätsänderung ein zweites Ausgangssignal (12) bereitzustellen, dabei ist die Auswerteeinheit (6) weiterhin dazu ausgestaltet das zweite Ausgangssignal (12) auszuwerten und bei Vorhandensein des zweiten Ausgangssignals (11) das Gültigkeitssignal (14) wieder zurückzunehmen.

3. Sensoranordnung (100) nach Anspruch 1 oder 2, wobei innerhalb der Eingabefläche (4) eine Fingermulde (9) angeordnet ist und der optische Sensor (3) unterhalb der Fingermulde (9) angeordnet ist.

4. Sensoranordnung (100) nach Anspruch 2 oder 3, wobei die Ergänzungsfläche (4a) ringförmig um die Eingabefläche (4) angeordnet ist.

5. Sensoranordnung (100) nach einem der Ansprüche 2 bis 4, wobei zwischen der Eingabefläche (4) und der Ergänzungsfläche (4a) ein Korridor (4b) angeordnet ist, welcher im Wesentlichen frei von einem elektrischen Fluss der kapazitiven Sensoren (1,2) ist.

6. Verfahren zum Betrieb einer Bedienvorrichtung mit zumindest einer Sensoranordnung (100) nach einem der der Ansprüche 1 bis 5, wobei einem ersten kapazitiven Sensor (1) eine Eingabefläche (4) zugeordnet wird, wobei ein Berühren der Eingabefläche (4) kapazitiv ausgewertet wird und ein erstes Ausgangssignal (11) für eine Bedienhandlung bereitgestellt wird, dabei wird eine Kapazitätsänderung des ersten kapazitiven Sensors (1) als Bedienhandlung gewertet,
**dadurch gekennzeichnet, dass** mittels eines optischen Sensors (3) eine Lichtdurchlässigkeits-Messung eines auf der Eingabefläche (4) befindlichen Objektes (8) durchgeführt wird und geprüft wird, ob eine ermittelte Lichtdurchlässigkeit einen vorgegebenen Wert unterschreitet, bei Unterschreitung des Wertes wird ein Präsenzsignal (13) erzeugt, weiterhin wird geprüft, ob das erste Ausgangssignal (11) und das Präsenzsignal (13) vorhanden sind und bei Vorhandensein beider Signale wird ein Gültigkeitssignal (14) bereitgestellt, wodurch die Bedienhandlung als gültig erkannt wird.

7. Verfahren nach Anspruch 6, wobei einem zweiten kapazitiven Sensor (1) eine Ergänzungsfläche (4a) zugeordnet wird und ein Berühren der Ergänzungsfläche (4a) kapazitiv ausgewertet wird und ein zweites Ausgangssignal (12) für ein Berühren der Ergänzungsfläche (4a) bereitgestellt wird, dabei wird eine Kapazitätsänderung des zweiten kapazitiven Sensors (2) als Fehlbedienung gewertet, und bei Vorhandensein des zweiten Ausgangssignals (12) wird das Gültigkeitssignal (14) wieder zurückgenommen.

8. Verfahren nach Anspruch 7, wobei ein elektrischer Fluss des zweiten Sensors (2) im Wesentlichen ringförmig um die Eingabefläche (4) ausgerichtet wird.

9. Verfahren nach Anspruch 7 oder 8, wobei der elektrische Fluss des zweiten Sensors (2) und ein elektrischer Fluss des ersten Sensors (1) derart ausgerichtet werden, dass zwischen der Eingabefläche (4) und der Ergänzungsfläche (4a) ein Korridor (4b) entsteht, welcher im Wesentlichen frei von einem elektrischen Fluss der kapazitiven Sensoren (1,2) ist.

## Claims

1. Sensor arrangement (100), comprising
an input surface (4), below which a first capacitive sensor (1) is disposed,
a means (7) for evaluating a change in capacitance of the first sensor (1), which is connected to said sensor and is embodied to provide a first output signal (11) if there is a change in capacitance,
**characterised in that** the input surface (4) has at least one light-permeable part surface (5) and an optical sensor (3) is disposed below the part surface (5), wherein the optical sensor (3) is connected to an evaluation unit (6) and the evaluation unit (6) is embodied to carry out a light-permeability measurement of an object (8) located on the input surface (4) by means of the optical sensor (3) and to create a presence signal (13) if a light permeability determined falls below a predetermined value, in this case the evaluation unit (6) is further embodied to evaluate the first output signal (11) and the presence signal (13) and, if both signals are present, to provide a validity signal (14).

2. Sensor arrangement (100) according to claim 1, with a supplementary surface (4a) below which a second capacitive sensor (2) is disposed, wherein the supplementary surface (4a) at least partly surrounds the input surface (4), wherein the means (7) for evaluating a change in capacitance of the first sensor (1) is additionally embodied also to evaluate a change in capacitance of the second sensor (2) and, if the capacitance has changed, to provide a second output signal (12), in this case the evaluation unit (6) is further embodied to evaluate the second output signal (12) and, if the second output signal (11) is present, to withdraw the validity signal (14) again.

3. Sensor arrangement (100) according to claim 1 or 2, wherein a depression for a finger (9) is disposed within the input surface (4) and the optical sensor (3) is disposed below the finger depression (9).

4. Sensor arrangement (100) according to claim 2 or 3, wherein the supplementary surface (4a) is disposed around the input surface (4) in the shape of a ring.

5. Sensor arrangement (100) according to one of claims 2 to 4, wherein a corridor (4b), which is essentially free from an electric flux of the capacitive sensors (1, 2), is disposed between the input surface (4) and the supplementary surface (4a).

6. Method for operating a operating device with at least one sensor arrangement (100) as claimed in one of claims 1 to 5, wherein an input surface (4) is assigned to a first capacitive sensor (1), wherein a touch on the input surface (4) is evaluated capacitively and a first output signal (11) is provided for an operator control action, in this case a change in capacitance of the first capacitive sensor (1) is judged as an operator control action,
**characterised in that** a light-permeability measurement of an object (8) located on the input surface (4) is performed by means of an optical sensor (3) and a check is made as to whether a light permeability determined falls below a predetermined value, if the value is below this value a presence signal (13) is created, furthermore a check is made as to whether the first output signal (11) and the presence signal (13) are present, and if the two signals are present a validity signal (14) is provided, by which the operator control action is recognised as valid.

7. Method according to claim 6, wherein a supplementary surface (4a) is assigned to the second capacitive sensor and a touch on the supplementary surface (4a) is evaluated capacitively and a second output signal (12) for a touch on the supplementary surface (4a) is provided, in this case a change in capacitance of the second capacitive sensor (2) is judged as an incorrect operation, and if the second output signal (12) is present the validity signal (14) is withdrawn again.

8. Method according to claim 7, wherein an electric flux of the second sensor (2) is essentially aligned in a ring shape around the input surface (4).

9. Method according to claim 7 or 8, whereby the electric flux of the second sensor (2) and an electric flux of the first sensor (1) are aligned so that a corridor (4b) which is essentially free from an electric flux of the capacitive sensors (1, 2) arises between the input surface (4) and the supplementary surface (4a).

## Revendications

1. Agencement ( 100 ) de capteurs comprenant
une surface ( 4 ) d'entrée, sous laquelle est disposé un premier capteur ( 1 ) capacitif,
un moyen ( 7 ) d'exploitation d'une variation de capacité du premier capteur ( 1 ), qui est relié à celui-ci et qui est conformé pour mettre à disposition un premier signal ( 11 ) de sortie s'il se produit une variation de la capacité, **caractérisé en ce que** la surface ( 4 ) d'entrée a au moins une surface ( 5 ) partielle transparente et il est disposé un capteur ( 3 ) optique sous la surface ( 5 ) partielle, le capteur ( 3 ) optique étant raccordé à une unité ( 6 ) d'exploitation et l'unité ( 6 ) d'exploitation étant conformée pour effectuer, au moyen du capteur ( 3 ) optique, une mesure de transparence à la lumière d'un objet ( 8 ) se trouvant sur la surface ( 4 ) d'entrée et pour produire un signal ( 13 ) de présence, si une transparence à la lumière qui a été déterminée est inférieure à une valeur donnée à l'avance, l'unité ( 6 ) d'exploitation étant pour cela conformée en outre pour exploiter le premier signal ( 11 ) de sortie et le signal ( 13 ) de présence et pour, en présence des deux signaux, mettre à disposition un signal ( 14 ) de validité.

2. Agencement ( 100 ) de capteurs suivant la revendication 1, ayant une surface ( 4a ) supplémentaire, sous laquelle est disposé un deuxième capteur ( 2 ) capacitif, la surface ( 4 ) supplémentaire entourant au moins en partie la surface ( 4 ) d'entrée, le moyen ( 7 ) d'exploitation d'une variation de capacité du premier capteur ( 1 ) étant conformé en outre pour exploiter aussi une variation de capacité du deuxième capteur ( 2 ) et pour, s'il se produit une variation de capacité, mettre à disposition un deuxième signal ( 12 ) de sortie, l'unité ( 6 ) d'exploitation étant conformée en outre pour exploiter le deuxième signal ( 12 ) de sortie et pour, en présence du deuxième signal ( 11 ), retirer le signal ( 14 ) de validité.

3. Agencement ( 100 ) de capteurs suivant la revendication 1, dans lequel il est disposé au sein de la surface ( 4 ) d'entrée une cuvette ( 9 ) pour le doigt et le capteur ( 3 ) optique est disposé en dessous de la cuvette ( 9 ) pour le doigt.

4. Agencement ( 100 ) de capteurs suivant la revendication 2 ou 3, dans lequel la surface ( 4a ) supplémentaire est disposée annulairement autour de la surface ( 4 ) d'entrée.

5. Agencement ( 100 ) de capteurs suivant l'une des revendications 2 ou 4, dans lequel il est disposé entre la surface ( 4 ) d'entrée et la surface ( 4a ) supplémentaire un corridor ( 4b ) qui est sensiblement exempt d'un flux électrique des capteurs ( 1, 2 ) capacitifs.

6. Procédé pour faire fonctionner un dispositif de commande ayant au moins un agencement ( 100 ) de capteurs suivant l'une des revendications 1 à 5, dans lequel on associe une surface ( 4 ) d'entrée et un premier capteur ( 1 ) capacitif, on exploite capacitivement un toucher de la surface ( 4 ) d'entrée et on met à disposition un premier signal ( 11 ) de sortie pour une manipulation de commande, une variation de la capacité du premier capteur ( 1 ) capacitif étant exploitée comme manipulation de commande, **caractérisé en ce que** l'on effectue, au moyen d'un capteur optique, une mesure de transparence d'un objet ( 8 ) se trouvant sur la surface ( 4 ) d'entrée et l'on contrôle si une transparence qui a été déterminée est inférieure à une valeur donnée à l'avance, on produit, si l'on est passé en dessous de la valeur, un signal ( 13 ) de présence, on contrôle en outre si le premier signal ( 11 ) de sortie et le signal ( 13 ) de présence sont présents et, en présence des deux signaux, on met à disposition un signal ( 14 ) de validité, par lequel la manipulation de commande est reconnue comme valable.

7. Procédé suivant la revendication 6, dans lequel on associe une surface ( 4a ) supplémentaire à un deuxième capteur ( 1 ) capacitif et on exploite capacitivement un toucher de la surface ( 4a ) supplémentaire et on met à disposition un signal ( 12 ) de sortie pour un toucher de la surface ( 4a ) supplémentaire, on exploite une variation de capacité du deuxième capteur ( 2 ) capacitif comme étant une commande erronée et, en présence du deuxième signal ( 12 ) de sortie, on retire le signal ( 14 ) de validité.

8. Procédé suivant la revendication 7, dans lequel on dirige un flux électrique du deuxième capteur ( 2 ) sensiblement annulairement autour de la surface ( 4 ) d'entrée.

9. Procédé suivant la revendication 7 ou 8, dans lequel on dirige le flux électrique du deuxième ( 2 ) et un flux électrique du premier capteur ( 1 ) de manière à créer entre la surface ( 4 ) d'entrée et la surface ( 4a ) supplémentaire un corridor ( 4b ) qui est sensiblement exempt d'un flux électrique des capteurs ( 1, 2 ) capacitifs.
